(19) Europäisches Patentamt
European Patent Office
Office européen des brevets

(11) Publication number: **0 260 349 A1**

(12) **EUROPEAN PATENT APPLICATION**

(21) Application number: 86201619.3

(22) Date of filing: 19.09.86

(51) Int. Cl.4: G03C 5/54, //G03F1/00,C09B29/48,C09B41/-00

(43) Date of publication of application: 23.03.88 Bulletin 88/12

(84) Designated Contracting States: AT BE CH DE FR GB IT LI LU NL SE

(71) Applicant: AGFA-GEVAERT naamloze vennootschap
Septestraat 27
B-2510 Mortsel(BE)

(72) Inventor: Kok, Piet
Albrecht Durerlaan 38
9910 GENT(BE)
Inventor: Van de Sande, Christian Charles
Tuinlaan 95
B-9180 Belsele(BE)
Inventor: De Rycke Gino Luc
Graaf d Urselstraat 1
B-2510 Mortsel(BE)

(54) **Dye diffusion transfer imaging process for production of retained images.**

(57) The present invention provides a dye diffusion transfer imaging process for the production of retained images, comprising the steps of:

-applying an alkaline aqueous processing composition to an image-wise exposed photographic element that contains in operative association with an alkali-permeable silver halide hydrophilic colloid emulsion layer a redox-activatable compound that initially is immobile in an aqueous alkali-permeable colloid medium and is capable of releasing under alkaline conditions in reduced state a diffusible dye moiety,

-providing a silver halide developing agent in said photographic element for being present therein during application of said alkaline aqueous processing composition to cause as a function of development of said silver halide emulsion layer the release of said diffusible dye moiety from said redox-activatable compound upon reduction thereof at the non-silver image areas or the loss of the capacity of said redox-activatable compound of releasing said diffusible dye moiety upon oxidation of said redox-activatable compound at the silver image areas, and

-allowing diffusion of said diffusible dye moiety into an extracting liquid or disposable receptor medium and leaving in said photographic element a silver image as well as an UV-absorbing dye image retained congruously with said silver image,

said redox-activatable compound comprising at least two dye units together absorbing radiation all over the range between 300 and 450 nm. The present invention also provides a photographic silver halide element comprising such a redox-activatable compound.

EP 0 260 349 A1

## DYE DIFFUSION TRANSFER IMAGING PROCESS FOR PRODUCTION OF RETAINED IMAGES

The present invention relates to a dye diffusion transfer imaging process for the production of retained images and to a photographic silver halide element comprising redox-activatable compounds having in their molecular structure at least two dye units or dye precursor units, which together absorb radiation substantially all over the range between 300 and 450 nm, said photographic element being capable of image-wise retaining a congruous image of silver and ultraviolet radiation-absorbing compound.

Well-known dye-diffusion transfer systems for the production of dye images operate with photosensitive silver halide elements, from which dye images operate with photosensitive silver halide elements, from which dye-providing compounds including dyes and dye precursors can be released image-wise as a function of the image-wise development of silver halide to silver. A survey of such processes has been given by Christian C. Van de Sande in Angew.Chem.Int.Ed.Engl. 22 (1983) 191-209.

Oxidizable dye-providing compounds that in oxidized form are stable but in reduced state set free a dye moiety by an elimination reaction have been described in DE-A 2,823,159 and DE-A 2,854,946. Compounds of this type can be used in reduced form in an unexposed silver halide emulsion material and are called IHO-compounds, IHO being an acronym for "Inhibited Hydrolysis by Oxidation". When used in the oxidized form these compounds are called IHR-compound, wherein IHR is the acronym for "Increased Hydrolysis by Reduction".

Reducible quinonoid IHR-compounds, which after reduction can undergo a dye release with an intramolecular nucleophilic displacement reaction have been described in DE-A 2,809,716 wherein these compounds are called BEND-compounds, BEND standing for "Ballasted Electron-accepting Nucleophilic Displacement".

Reducible IHR-compounds, which after reduction can undergo a dye release with an elimination reaction have been described in the published EP-A 0,004,399 and in the US-P 4,371,604.

Other classes of compounds that may release a dye after reduction have been described in DE-A 3,008,588 and DE-A 3,014,669.

Particularly useful are the redox-controlled compounds that can be represented by:

BALL-REDOX-DYE:

wherein:

BAL represents a moiety with ballast residue for immobilizing the dye-releasing compound in a hydrophilic colloid layer,

REDOX represents a redox-active group, i.e. a group that under the circumstances of alkaline silver halide development is oxidizable or reducible and depending on the oxidized or reduced state brings about a release of diffusible dye by an elimination reaction, nucleophilic displacement reaction, hydrolysis, or cleavage reaction,

DYE represents a diffusible dye moiety or a precursor thereof.

The diffusible part is eliminated from the photosensitive element by causing it to migrate into a treatment liquid or by transferring it by diffusion into a layer containing a mordant. A residual image of dye is left in the photosensitive element, which image is also called "retained image". The latter terminology is used e.g. in Research Disclosure N°17362 (September 1978).

It is further known from EP-A 0,149,260 to enhance the colour density in dye diffusion transfer photography by the use of dye-providing compounds, which comprise a plurality of chromophoric groups.

On the other hand it is known to use photopolymers in resist materials as used e.g. for lithographic plate making and for printed circuit and integrated circuit production. The spectral sensitivity of most of the commercially available photopolymers is always found to range somewhere between 300 and 450 nm, their maximum speed generally lying between 350 and 400 nm. For details about photopolymers and processes for making photoresists reference can be made to "Photoresist, materials and processes" by W.S. De Forest, edited by McGraw-Hill Book Company, New York and London.

To image-wise expose such resist materials to ultraviolet radiation a mask is usually placed between the UV-lamp and the resist material. This mask is an intermediate negative or positive currently made according to classical photographic systems with light-sensitive materials having a high silver content. A mask essentially consisting of silver offers the advantage that silver absorbs radiation uniformly in all spectral fields including the ultraviolet field. However, silver is expensive and systems using silver-based light-sensitive materials commonly require several treating steps, which makes these systems time-consuming and inconvenient. Moreover, large amounts of water are needed during the processing of such materials. The resulting waste waters appear to be contaminated by different chemicals, which constitutes a hazard to the environment.

According to the present invention a dye diffusion transfer imaging process is provided, by means of which masks for reproduction on ultraviolet radiation-sensitive photopolymer resist materials can be produced in a fast, inexpensive, not ecologically harmful, and convenient way.

The present invention provides a dye diffusion transfer imaging process for the production of retained images, characterized in that said process comprises the steps of:

-applying an alkaline aqueous processing composition to an image-wise exposed photographic element that contains in operative association with at least one alkali-permeable silver halide hydrophilic colloid emulsion layer a redox-activatable compound that initially is immobile in an aqueous alkali-permeable colloid medium and is capable of releasing under alkaline conditions in reduced state a diffusible dye moiety,

-providing a silver halide developing agent in said photographic element for being present therein during application of said alkaline aqueous processing composition to cause as a function of development of said silver halide emulsion layer the release of said diffusible dye moiety from said redox-activatable compound upon reduction thereof at the non-silver image areas or the loss of the capacity of said redox-activatable compound of releasing said diffusible dye moiety upon oxidation of said redox-activatable compound at the silver image areas, and

-allowing diffusion of said diffusible dye moiety into an extracting liquid or disposable receptor medium and leaving in said photographic element a silver image as well as an UV-absorbing dye image retained congruously with said silver image

said redox-activatable compound comprising at least two dye units or dye precursor units, which together absorb radiation substantially all over the range between 300 and 450 nm.

The present invention also provides a photographic silver halide element comprising on a transparent support at least one alkali-permeable silver halide hydrophilic colloid emulsion layer and operatively associated with said emulsion layer a redox-activatable compound that initially is immobile in an aqueous alkali-permeable colloid medium and is capable of releasing under alkaline conditions in reduced state a diffusible dye moiety, characterized in that said redox-activatable compound comprises at least two dye units or dye precursor units, which together absorb radiation substantially all over the range between 300 and 450 nm.

The term "diffusing" as used herein means "having the property of diffusing effectively through the colloid layers of the photographic elements of the present invention in alkaline liquid medium". "Mobile" has the same meaning. The terms "non-diffusing" and "immobile" have the converse meaning. The term "diffusible" means "having the capacity of diffusing".

By "operatively associated" as used herein is to be understood that the release of a diffusible dye moiety from the redox-activatable compound can proceed in accordance with the development of the silver halide emulsion layer. Therefore, the redox-activatable compound does not have to be present in the silver halide emulsion layer itself but it may be contained in another layer that is in water-permeable relationship therewith.

In order that the retained dye image be congruous with the silver image it is necessary that the release of the diffusible dye moiety from the redox-activatable compound occurs upon reduction thereof at the non-silver image areas or that the redox-activatable compound has lost its capacity of releasing a dye upon oxidation thereof at the silver image areas. In other words only systems, which release in reduoed state can be taken into account.

Redox-activatable compounds comprising at least two dye units or dye precursor units, which together absorb radiation substantially all over the range between 300 and 450 nm and which can be used successfully in accordance with the present invention, can be represented by the following general formula (I):

CAR - L - D (I)

wherein:

CAR represents a carrier moiety, e.g. as described hereinafter,

L represents a chemical group cleavable or releasable from the carrier moiety by a redox reaction in alkaline aqueous medium, and

D represents a dye moiety or dye precursor moiety containing several dye units or dye precursor units, each of which has an absorption maximum between 300 and 450 nm and together absorbing radiation substantially all over the range between 300 and 450 nm, said dye units or dye precursor units being linked chemically to each other by:

-a non-metal atom bearing only single bonds, e.g. -O-or -S-, or

-a polyvalent atom group wherein one atom links the dye units together by single bonds only, e.g.

-$SO_2$-, -$CH_2$-, or -NH-, or

-a polyvalent atom group forming between the dye units a chain of atoms wherein at least one atom of the interlinking atoms of the backbone part of said chain has two consecutive single bonds in said backbone part.

Representatives of these redox-activatable compounds comprise a moiety D corresponding to the following general formula (II):

$-(A)_x[-B(-C)_y]_z$ (II)

wherein:

A is $L^1$, $L^1D^1$ or $D^1$,
B is $L^2$, $L^2D^2$ or $D^2$,
C is $L^3$, $L^3D^3$ or $D^3$,
x is 0 or 1,
y is 0, 1, 2, or 3, and
z is 1, 2, or 3,
at least 2 members, preferably from 2 to 5 members, being selected from the group consisting of $D^1$, $D^2$ and $D^3$ and, when y and/or z are 2 or 3, both the several groups B and the several groups C having same or different meanings, and
wherein :
each of $L^1$, $L^2$ and $L^3$ (same or different) represents a non-conjugating linking member being a collective expression for:

-a non-metal atom bearing only single bonds, e.g. -O-or -S-, or

-a polyvalent atom group wherein one atom links the dye units together by single bonds only, e.g. -$SO_2$-, -$CH_2$-, or -NH-, or

-a polyvalent atom group forming between the dye units a chain of atoms wherein at least one atom of the interlinking atoms of the backbone part of said chain has two consecutive single bonds in said backbone part, e.g. -$SO_2$NH-, -CONH-, bivalent non-conjugating hydrocarbon such as alkylene or trivalent non-conjugating groups, examples of which are given hereinafter, and

each of $D^1$, $D^2$, and $D^3$ (same or different) represents a dye unit or dye precursor unit having an absorption maximum between 300 and 450 nm, the members present of $D^1$, $D^2$, and $D^3$ together absorbing radiation substantially all over the range between 300 and 450 nm.

Examples of polyvalent $L^1$, $L^2$, and $L^3$ non-conjugating linking members are :

$$-CONH-(CH_2)_2-NHSO_2-$$

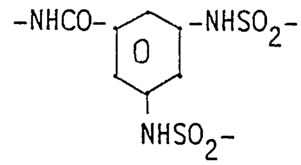

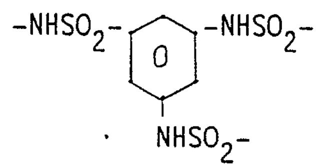

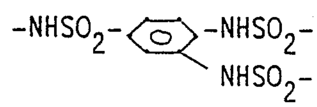

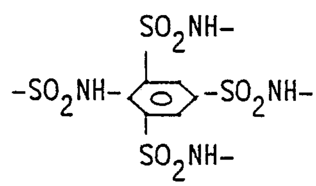

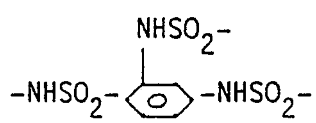

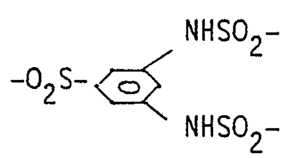

The dye units or their precursors can be chosen from such known classes of UV-absorbing compounds like i.a. arylpyrazolidinone-azo compounds, arylquinolinones, triazoles, benzotriazoles, benzothiazoles, benzothiadiazoles, thiazolothiazoles, naphthotriazoles, benzoselenadiazoles, thiazolidones, dihydroxybenzophenones, pyrones, arylidenefluorenes, styryl derivatives, heterocyclic azines, cyanomethyl sulphone-derived merocyanines, etc. Any UV-absorbing compound of these or other known classes can be used, provided it has an absorption maximum between 300 and 450 nm and can be introduced by an appropriate reaction into the molecular structure of the redox-activatable compounds for use in accordance with the present invention. Dye precursors are either derivatives setting free the actual dye by alkaline hydrolysis or are compounds that generate the dye e.g. from a leuco dye form by oxidation.

Particularly useful dye units or their precursors correspond to the following structural formulae:

(1) 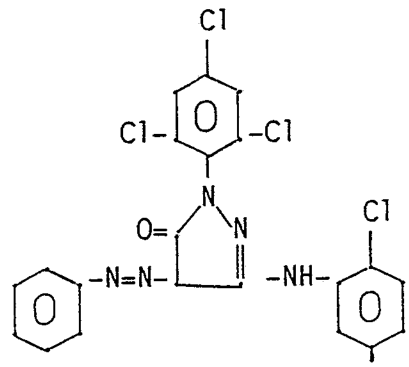

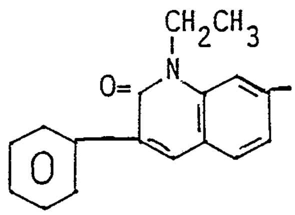

Examples of reducible carrier moieties (CAR-L-), from which a diffusible dye moiety can be set free upon reduction at the non-silver image areas are the following :

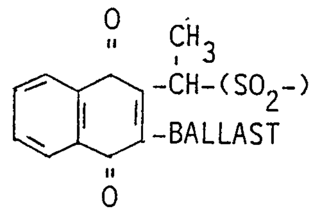

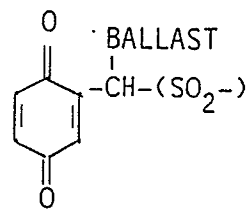

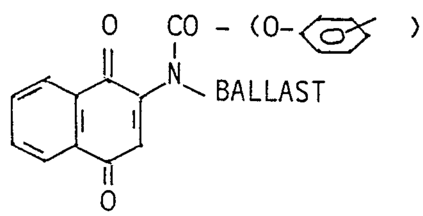

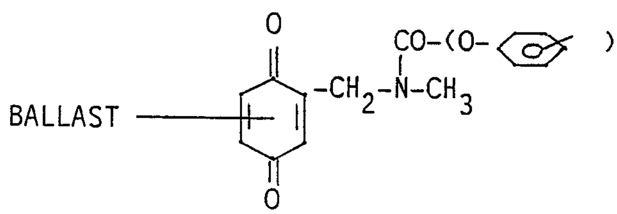

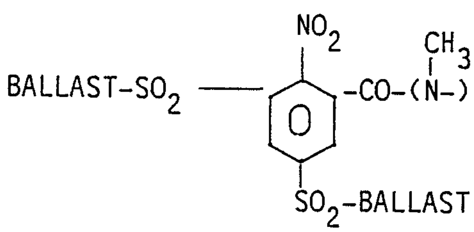

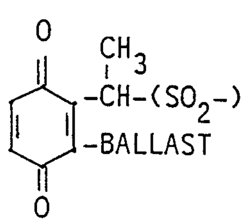

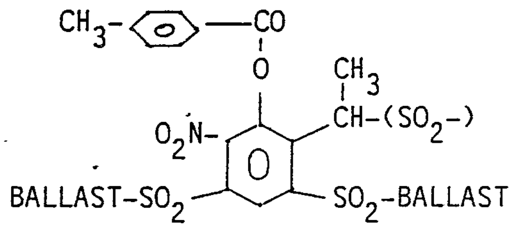

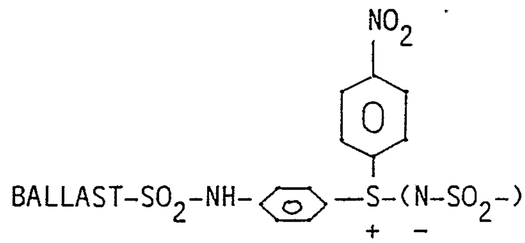

The groups within brackets are functional groups that are split off together with the dye moiety (not shown). These functional groups can be separated from the chromophoric group of the dye by a linking member. The functional group, however, optionally together with said linking member, may be of importance to determine the diffusion-mobility and/or capability of the released dye to be mordanted. Useful linking members are e.g. alkylene and arylene groups.

Ballast residues that confer diffusion resistance are residues, which allow the compounds for use according to the invention to be incorporated in non-diffusing form in the hydrophilic colloids normally used in photographic elements. Organic residues, which generally carry straight-chain or branched-chain aliphatic groups and also isocyclic or heterocyclic or aromatic groups usually having from 8 to 20 carbon atoms are preferred for this purpose. These residues are attached directly or indirectly to the molecule, e.g. indirectly through one of the following groups : -NHCO-; $-NHSO_2-$; -NR-(R representing hydrogen or alkyl; -O-; -S-; or $-SO_2-$. Additionally, the residue that confers diffusion resistance may also carry groups conferring solubility in water, e.g. sulpho groups or carboxy groups, and these may also be present in anionic form. Since the diffusion properties depend on the molecular size of the compound as a whole, it may be possible in the case of compounds having a high molecular weight that only one or a few short-chain groups confer a satisfactory resistance to diffusion.

The reaction operative in the release of a dye moiety from reducible IHR-compounds e.g. quinonoid IHR-compounds proceeds in two stages (A) and (B) illustrated by the following equations (IHR-mode):

A)

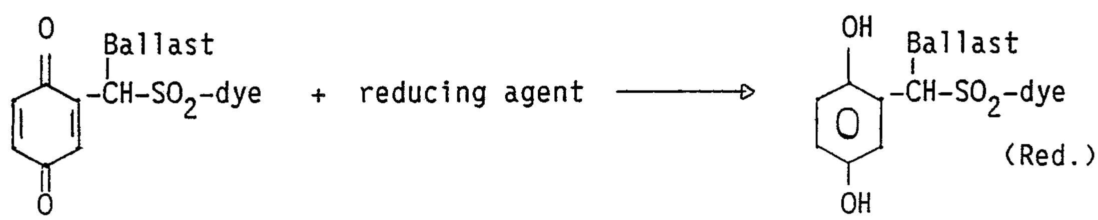


B)

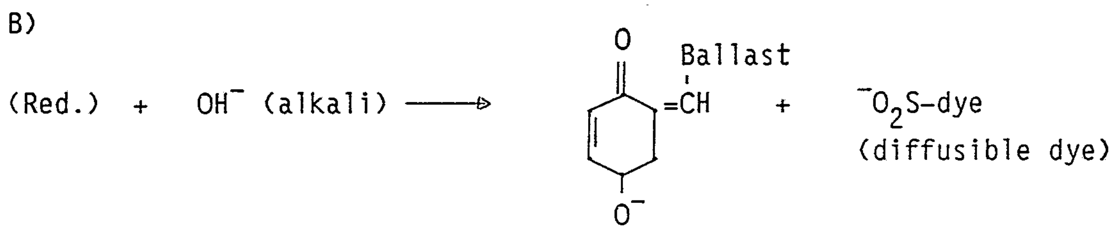


wherein :
"Ballast" stands for a ballasting group making the compound non-diffusing in a hydrophilic colloid medium under wet alkaline conditions.

The above quinonoid compounds can also be used in the reduced hydroquinonoid form. In this case the release of the diffusible dye moiety takes place at the non-silver image areas but according to a different mechanism outlined as follows (IHO-mode):

A)

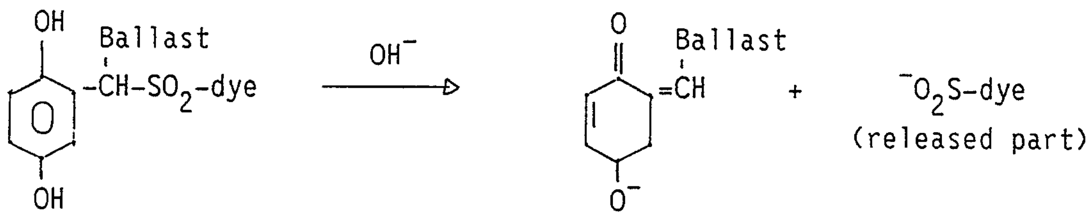


B)

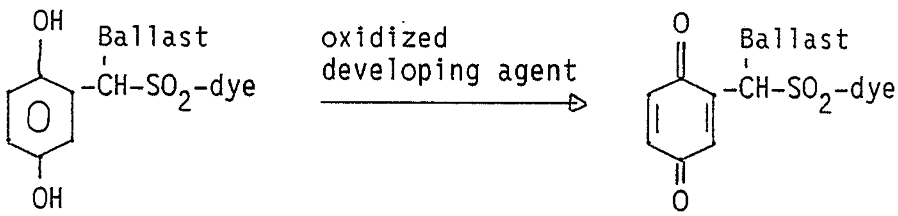


wherein:
"Ballast" again stands for a ballasting group making the compound non-diffusing in a hydrophilic colloid medium under wet alkaline conditions.

At the places where no oxidized developing agent is formed, the redox-ativatable compound enters into reaction with $OH^-$ and splits, thus releasing a diffusible dye moiety that migrates from the emulsion layer towards an extracting liquid or a disposable receptor medium. In the case of direct-positive silver halide emulsions the release occurs at the exposed areas, in the case of negative emulsions at the unexposed areas.

At the places where oxidized developing agent is formed, the redox-activatable compound is oxidized into the quinone form and thus looses its capacity of releasing a diffusible dye moiety. In the case of direct-positive silver halide emulsions this occurs at the unexposed areas, in the case of negative emulsions at the exposed areas.

According to the present invention both negative silver halide emulsions and direct-positive emulsions can be used in the IHO-mode as well as in the IHR-mode.

Examples of carrier moieties (CAR-L-), from which a diffusible dye can be set free upon oxidation, are the following:

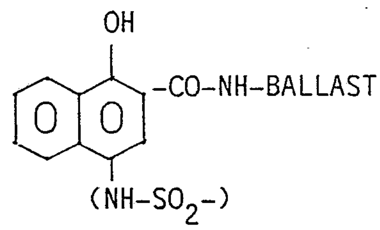

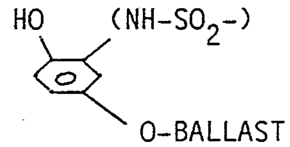

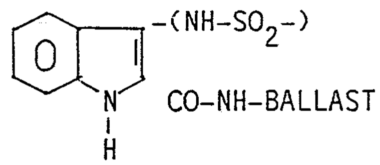

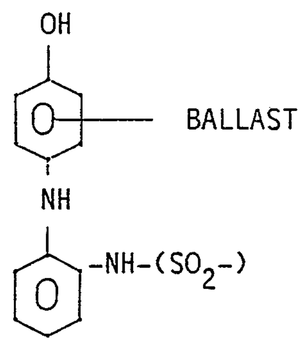

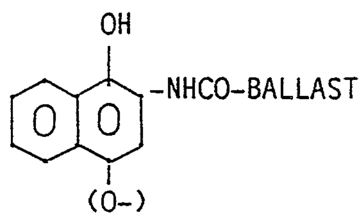

The dye image retained in the developed photographic element according to the present invention is congruous with the silver image, which is in favour of image density and silver economy. The maximum density obtainable with the congruous silver and dye image is higher than 3.5 and in most cases even higher than 4. This is in spite of the low silver content of the silver halide emulsion layer of the photographic element as defined hereinafter. The retained dye image formed in the photographic element according to the present invention comprises at least two dye units, which together are capable of absorbing substantially all radiation emitted by UV-lamps commonly used for image-wise exposing photopolymer resist materials. As a result the silver and retained dye image obtained with a photographic element according to the present invention constitutes a mask, which during exposure of photopolymer resist materials to UV-radiation only transmits such radiation in the areas where no retained image is present.

Examples of redox-activatable compounds that can be used successfully according to the present invention are the compounds corresponding to the following structural formulae:

Compound RA.1

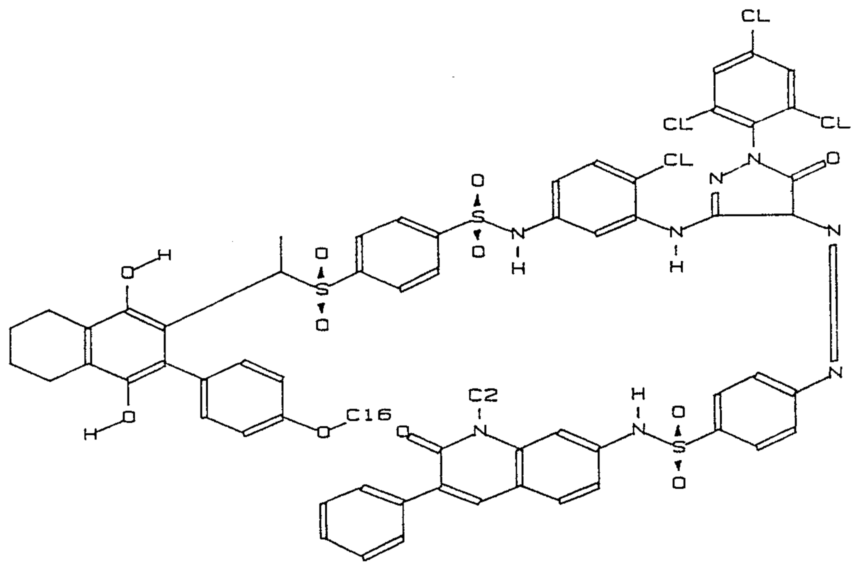

Compound RA.2

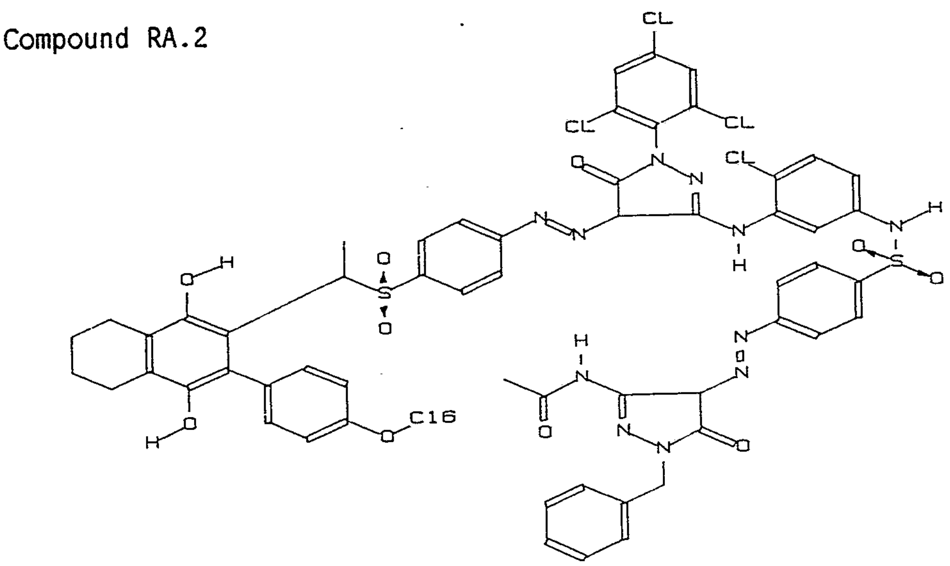

Compound RA.3

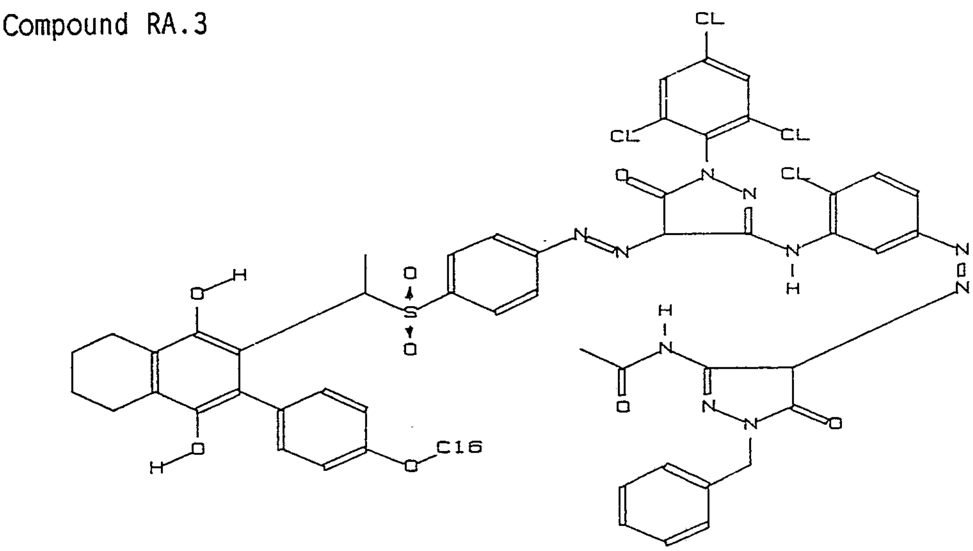

Compound RA.4

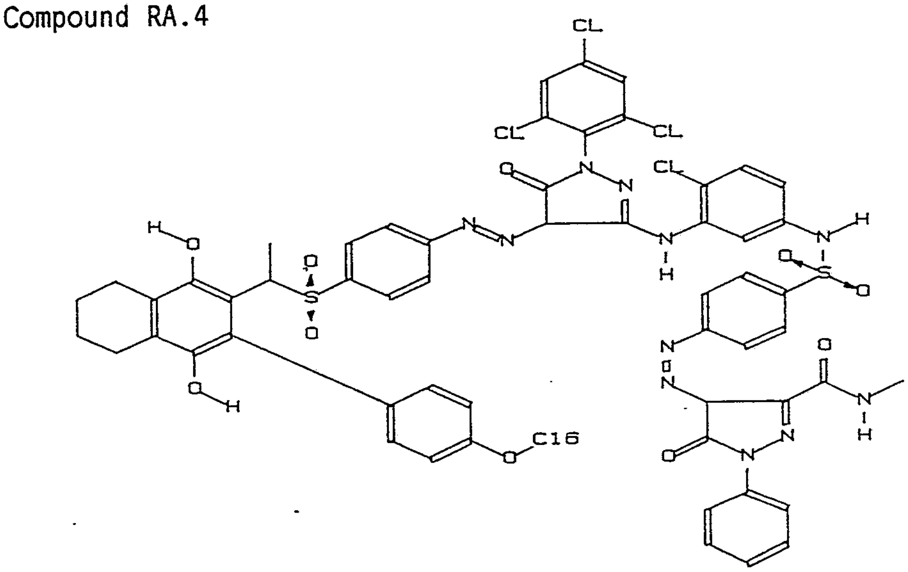

Compound RA.5

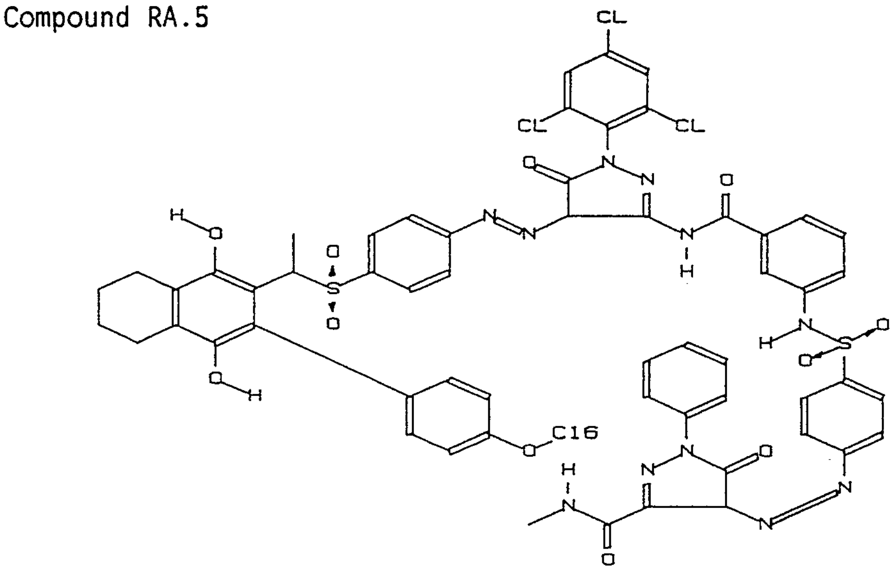

Compound RA.6

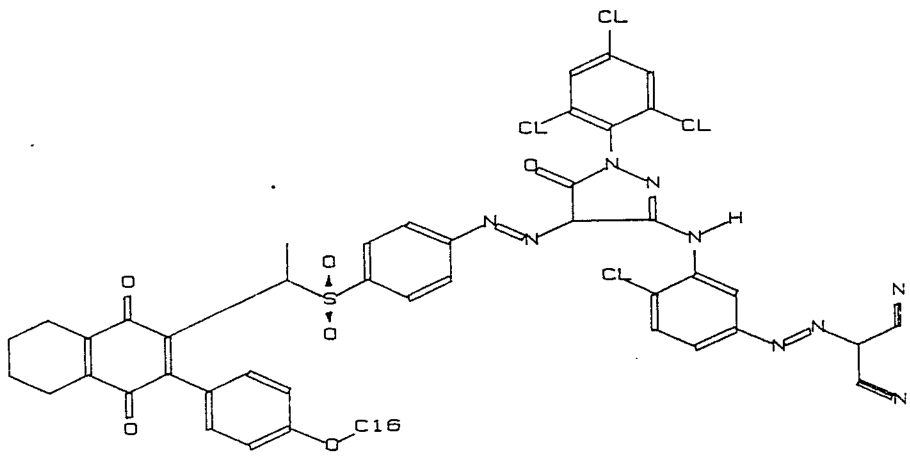

Compound RA.7

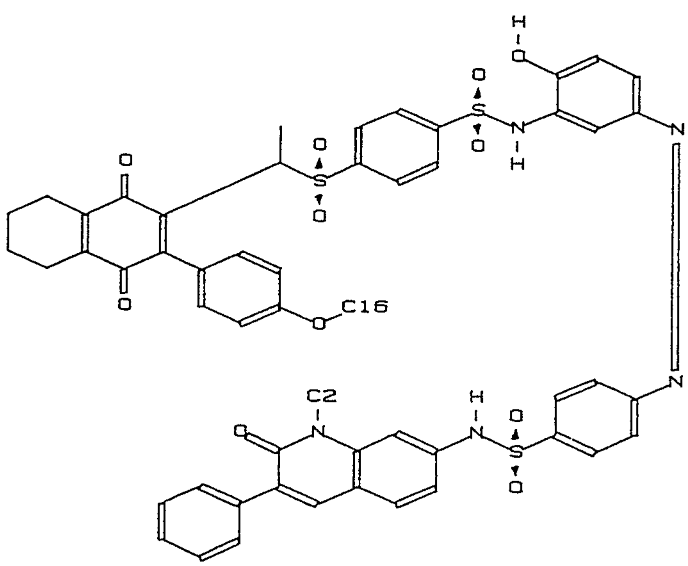

Compound RA.8

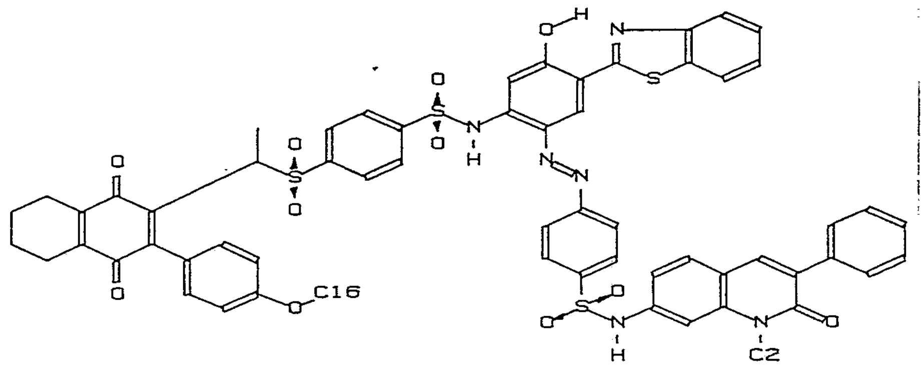

Compound RA.9

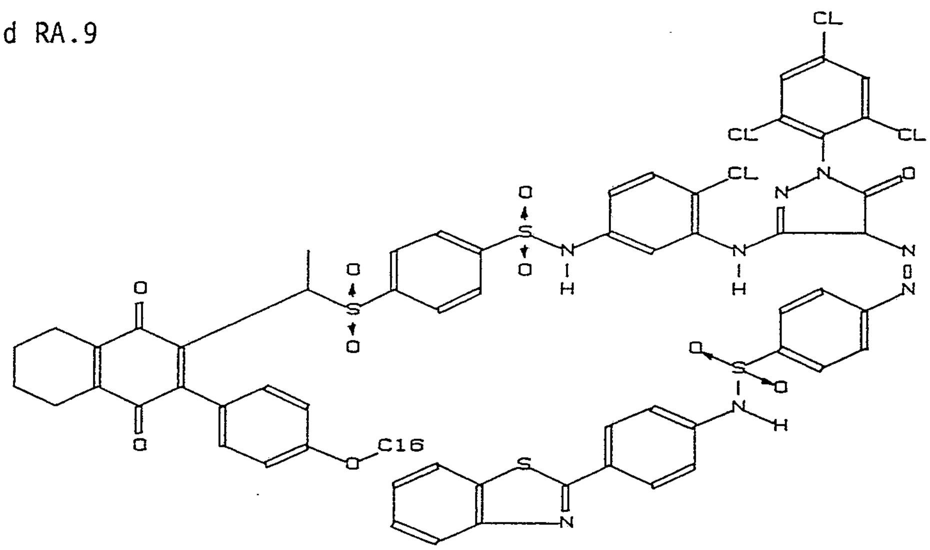

A redox-activatable compound used preferentially according to the present invention is the above identified compound RA.1.

The synthesis of the particularly useful redox-activatable compound RA.1 according to the present invention is illustrated by the following reaction scheme and preparation.

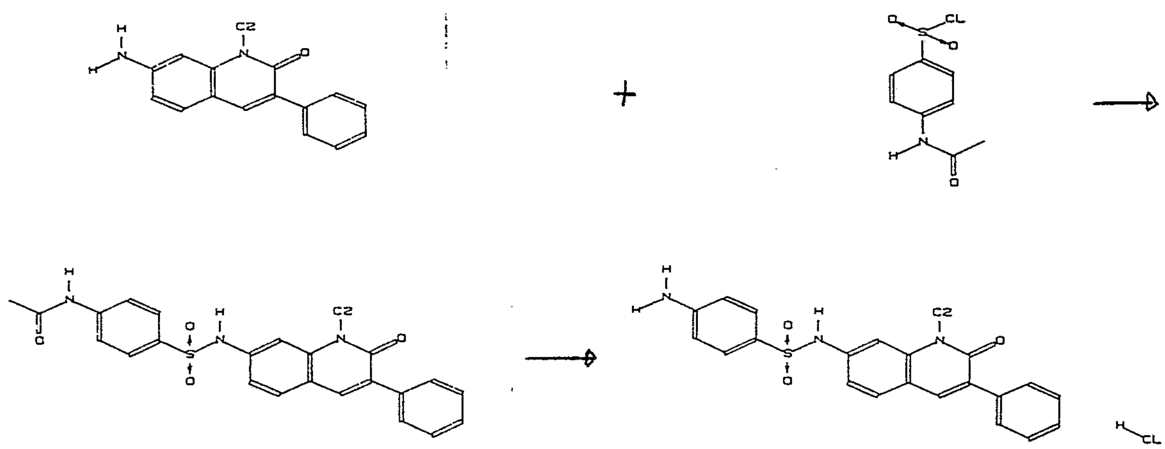

Compound RA.1a

Compound RA.1b

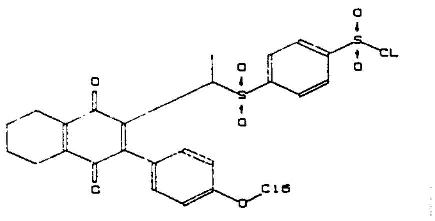

+

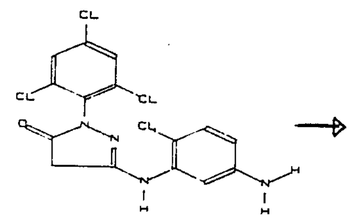

Compound RA.1c

Compound RA.1d

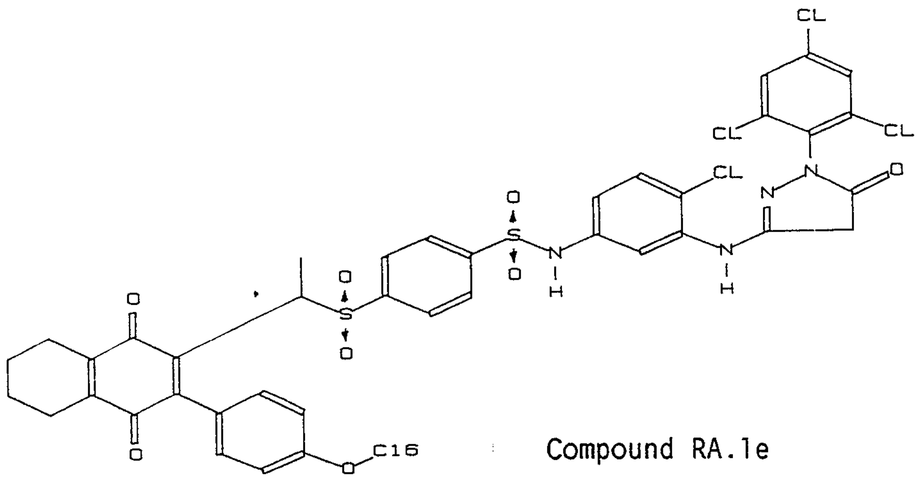

Compound RA.1e

RA.1b + RA.1e

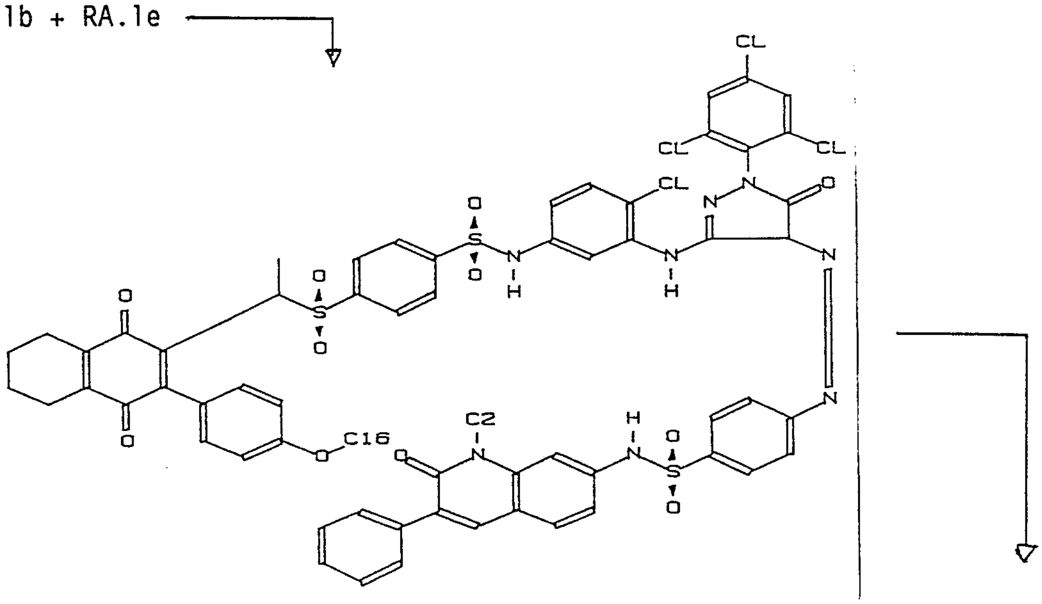

RA.1f

Compound RA.1

PREPARATION OF COMPOUND RA.1

Intermediate compound RA.1a

At room temperature 151 g (0.65 mol) of 4-acetamidobenzene sulphochloride is added to a solution of 132 g (0.5 mol) of 7-amino-1-ethyl-3-phenyl-carbostyril in 112.5 ml of pyridine and 2 1 of methylene chloride. The temperature rises to 40°C. The reaction mixture is stirred for 20 h at room temperature. The precipitate is filtered off and rinsed with 500 ml of methylene chloride. The product obtained is stirred with 1.5 l of methylene chloride. After 30 min the precipitate is filtered and rinsed again with 500 ml of methylene chloride. Compound RA.1a is dried at 75°C under reduced pressure.
Yield of compound RA.1a: 230 g (99.8%)

Intermediate compound RA.1b

An amount of 230 g (0.5 mol) of Compound RA.1a is refluxed for 4 h in a mixture of 0.5 l of concentrated hydrochloric acid and 2 l of ethanol. The reaction mixture is allowed to cool overnight. A volume of 0.8 l of water is then added. The mixture is cooled to 0°C. The precipitate is filtered and boiled up with 0.8 l of ethanol. After cooling the precipitate is filtered and dried under reduced pressure.
Yield of compound RA.1b: 179 g (78%)

Intermediate compound RA.1e

An amount of 30 g (0.04 mol) of Compound RA.1c, the synthesis of which has been described in EP-A 0,173,361, is added at room temperature to a mixture of 16.16 g (0.04 mol) of 1-(2,4,6-trichlorophenyl)-3-(5-amino-2-chloroanilino)-2-pyrazolin-5-one (Compound RA.1d), 32 ml of pyridine, and 320 ml of methylene chloride. After 2 h a further amount of 3 g of Compound RA.1c is added to the reaction mixture. Two hours later thin layer chromatography proves that compound RA.1d is still present in the reaction mixture. A further amount of 3 g of Compound RA.1c is added to the reaction mixture. After stirring for 16 h at room temperature the reaction mixture is concentrated by evaporation under reduced pressure. The residue is recrystallized from 350 ml of isopropanol.
Yield of compound RA.1e: 42.5 g (96%)

Intermediate compound RA.1f

An amount of 12.2 g (0.18 mol) of sodium nitrite dissolved in 35 ml of water is added at 0°C to a mixture of 68.5 g (0.15 mol) of Compound RA.1b, 49 ml of concentrated hydrochloric acid, and 1.3 1 of acetone. After 2 h of stirring at 0°C 167 g (0.15 mol) of compound RA.1e is added to the reaction mixture, which is then stirred for 3 more hours at room temperature. An amount of 60 g of sodium hydrogen carbonate is added to the reaction mixture. After 30 min 175 ml of acetic acid and 1.5 l of water is added. The resulting precipitate is filtered with suction, rinsed with water, and dried under reduced pressure.
Yield of compound RA.1f: 232g (100%)

Compound RA.1

A mixture of 154.2 g (0.1 mol) of compound RA.1f and 20.5 g (0.12 mol) of 1-phenyl-pyrazolidin-3-one in 3.25 l of ethanol is refluxed for 2 h. A further amount of 2 g of 1-phenyl-pyrazolidin-3-one is added and refluxing is continued for 2 h. The reaction mixture is cooled on an ice-bath. The precipitate is filtered with suction and dried under reduced pressure. The resulting product is puridfied by column chromatography.
Yield of compound RA.1: 109 g (75%)

Other redox-activatable compounds for use according to the present invention can be prepared analogously or by techniques known in the art starting with the appropriate chemicals.

A photographic silver halide emulsion element according to the present invention comprises a transparent support and at least one alkali-permeable silver halide hydrophilic colloid emulsion layer, which can be of the negative-working type or of the direct-positive type depending on whether the redox-activatable compounds comprises a reducible carrier moiety or an oxidizable carrier moiety respectively.

The dye release reaction can be promoted by the presence of so-called electron donor compounds (ED-compounds) and so-called electron-transfer agents (ETA-compound) respectively.

The ED-compounds are preferably non-diffusing. They can e.g. be provided with a ballasting group, so that they remain in the layer unit, in which they have to transfer their electrons to the redox-activatable compounds. They are preferably present in non-diffusing state in the silver halide emulsion layer containing the non-diffusing redox-activatable compound. They can also be incorporated into an antistress layer. Examples of such ED-compounds are ascorbyl palmitate and 2,5-bis(1′,1′,3′,3′-tetramethylbutyl)-hydroquinone. Other ED-compounds have been disclosed in US-A 4,139,379 and in DE-A 2,947,425. Instead of an ED-compound an electron-donor precursor (EDP) compound can be used in the photographic element as described e.g. in published DE-A 2,809,716 and in US-A 4,278,750. Other particularly useful ED-precursor compounds have been described in EP-A 0,124,915, which corresponds with US Ser.No. 06/581,723 and in DE-A 3,006,268.

The ETA-compound is preferably used as developing agent in diffusible state and is incorporated e.g. in mobile form in (a) hydrophilic colloid layer(s) adjacent to a silver halide emulsion layer or is applied from the processing liquid.

Typically useful ETA-compounds include hydroquinone compounds, aminophenol compounds, catechol compounds, phenylenediamines and pyrazolidin-3-one compounds e.g. 1-aryl-pyrazolidin-3-one as described in e.g. US-A 4,139,379.

A combination of different ETA-compounds such as those disclosed in US-A 3,039,869 can be employed likewise. Such developing agents can be present in the liquid processing composition or can be contained, at least in part, in any layer or layers of the photographic element such as in the silver halide emulsion layers, interlayers, etc. The selection of a specific ETA will, of course, depend on the particular electron-donor and redox-activatable compound used and on the processing conditions for the particular photographic element.

The concentration of ED-compound or ED-precursor compound in the photographic element may vary within a broad range but is e.g. in the molar range of 1:1 to 8:1 in respect of the redox-activatable compound. The ETA-compound can be present in the alkaline aqueous liquid used in the development step, but is contained preferably in diffusible form in a non-light-sensitive hydrophilic colloid layer adjacent to the silver halide emulsion layer e.g. in an antistress layer.

The redox-activatable compounds and optionally ED or ED-precursor compounds can be incorporated into the photographic element by addition to the coating composition(s) of one or more of its composite layer(s) according to usual methods known e.g. for incorporating colour couplers into photographic silver halide emulsion elements.

High concentrations of ETA-compound and of ED-compound should be avoided, because in both cases a spontaneous reaction with IHR-dye can be induced, which may result in reversal effects and an accompanying loss in maximum density. To avoid these effects a few tests can be made so as to determine the optimal concentrations. In another way of avoiding these effects the redox-activatable compounds can be employed preferably in the IHO form.

The amount of redox-activatable compound coated per m2 may vary within wide limits and depends on the maximum density desired. Preferred amounts vary between 0.1 and 1.5 g per m2 of photographic element.

The photographic element comprising a silver image and a congruous retained dye image may contain agents that improve or stabilize the image e.g. dye stabilizers such as the chromanols, alkyl-phenols, etc.

The light-sensitive silver halide of the photographic element according to the present invention can be a mixture of different silver halides e.g. silver chlorobromide or silver chlorobromoiodide, but preferably it comprises a high content of silver chloride, the best results being obtained with a pure silver chloride emulsion.

According to a preferred embodiment of the present invention the silver halide used for the photographic element is a pure silver chloride emulsion that has been sensitized chemically with rhodium.

Inasmuch as the retained dye image is congruous with the silver image obtained in the photographic element according to the present invention, the silver content of the light-sensitive silver halide emulsion layer can be very low. An amount of silver equivalent to 0.3 to 1.5 g of silver nitrate per m2 of emulsion layer yields very good results.

The transparent support for the photographic elements of this invention may be any transparent film material as long as it does not deleteriously affect the photographic properties of the photographic elements and is dimensionally stable. Typical transparent film material that can be used according to the present invention is cellulose nitrate, cellulose acetate, polyvinyl acetal, polystyrene, polyethylene terephthalate, polycarbonate, polyalkylene such as polyethylene and polypropylene, and resinous material. The support is

usually about 0.05 to 0.18 mm thick. The support is preferably coated with at least one subbing layer to improve the adherence thereto of hydrophilic colloid layers e.g. of silver halide emulsion layers. Suitable subbing layers for that purpose have been described in e.g. US-A 3,495,984; US-A 3,495,985; US-A 3,434,840; US-A 3,788,856; and GB-A 1,234,755.

The photographic element may comprise an antihalation layer to counteract the reflection of halation light.

An alkaline processing composition employed in the production of silver and retained dye images according to the present invention can be a conventional aqueous solution of an alkaline substance e.g. sodium hydroxide, sodium carbonate or an amine such as diethylamine, preferably having a pH-value higher than 11.

According to one embodiment the alkaline processing liquid contains the diffusible developing agent that effects the reduction of the silver halide, e.g. ascorbic acid or a 3-pyrazolidinone developing agent such as 1-phenyl-4-methyl-3-pyrazolidinone.

The alkaline processing composition employed in this invention may also contain a desensitizing agent such as methylene blue, nitro-substituted heterocyclic compounds, 4,4'-bispyridinium salts, etc., to ensure that the photographic element is not further exposed between the image-wise exposure and the processing.

The processing can be performed in a tray developing unit as is contained e.g. in an ordinary silver complex diffusion transfer (DTR) apparatus, in which a receptor medium is brought in contact with the photographic element after having absorbed a sufficient amount of processing liquid. A suitable apparatus for said purpose is the COPYPROOF CP 38 (trade name) DTR-developing apparatus. COPYPROOF is a trade name of Agfa-Gevaert, Antwerp/Leverkusen.

The receptor medium can be any material capable of mordanting or otherwise fixing the diffused dye. The particular material chosen will, of course, depend upon the dye to be mordanted. If acid dyes are to be mordanted, the receptor medium may be composed of or contain basic polymeric mordants such as polymers of amino-guanidine derivatives of vinyl methyl ketone such as described in US-P 2,882,156 of Louis M.Minsk, issued April 14, 1959, and basic polymeric mordants and derivatives, e.g. poly-4-vinylpyridine, the metho-p-toluene sulphonate of 2-vinylpyridine and similar compounds described in US-A 2,484,430 of Robert H.Sprague and Leslie G.Brooker, issued October 11, 1949, and the compounds described in the published DE-A 2,200,063 filed January 11, 1971 by Agfa-Gevaert A.G. Suitable mordanting binders include e.g. guanylhydrazone derivatives of acyl styrene polymers, as described e.g. in published DE-A 2,009,498 filed February 28, 1970 by Agfa-Gevaert A.G. In general, however, other binders, e.g. gelatin, would be added to the last-mentioned mordanting binders. Effective mordanting compositions are long-chain quaternary ammonium or phosphonium compounds or ternary sulphonium compounds e.g. those described in US-A 3,271,147 of Walter M.Bush and 3,271,148 of Keith E.Whitmore, both issued September 6, 1966, and cetyltrimethyl-ammonium bromide. Certain metal salts and their hydroxides that form sparingly soluble compounds with the acid dyes can be used too. The dye mordants are dispersed in one of the usual hydrophilic binders in the image-receiving layer, e.g. in gelatin, polyvinylpyrrolidone or partly or completely hydrolysed cellulose esters.

The receptor medium carrying the transferred dye moiety has no further use and can be disposed of.

Instead of a receptor medium an extracting liquid can be used to receive and fix the diffusing dye moieties. Details about such extracting liquid can be found in Research Disclosure N° 22711 (March 1983).

Although it is customary that the dye diffusion transfer imaging process for making retained images according to the present invention makes use of an alkaline aqueous processing composition, the scope of the present invention is not restricted to such wet processing systems. It is indeed also possible to incorporate the necessary processing ingredients into the photographic material and to start the imaging process after the image-wise exposure by applying overall heat. Reference can be made in this respect to EP-A 0,120,306 and to DE-OS 3,413,096.

It is also possible to use a processing web or sheet as described in the EP application 85201740.9 in the production of retained images according to the present invention, the processing web or sheet conprising the necessary processing ingredients and a mordanting agent for fixing the dye transferred from the developed photographic element.

The following examples illustrate the present invention. The amounts given are per m2.

EXAMPLE

A strip of subbed polyethylene terephthalate support having a thickness of 0.1 mm was coated with the following layers in the given order:

1) a silver halide emulsion layer containing: gelatin 1.8 g
AgCl expressed as $AgNO_3$ 0.5 g
redox-activatable compound RA.1 0.333 g
ED compound: 2,5-bis(1′,1′,3′,3′-tetramethyl-butyl)-hydroquinone 0.01 g

2) protective layer containing:
gelatin 6 g
1-phenyl-4-methyl-3-pyrazolidinone 0.12 g
citric acid up to a pH of 4.5 in both layers 0.06 g

The resulting photographic silver halide element was exposed in a KLIMSCH KL 21 device while in contact with a step wedge having a constant of 0.15 and then developed by immersion for 30 s in a solution having the following composition:

sodium hydroxide 28 g
sodium phosphate 25 g
sodium thiosulphate 2 g
potassium bromide 1 g
cyclohexane dimethanol 32 g
methylpropylpropane diol 25 g
water to make 1 1

The developed element was rinsed for 1 min in running water, fixed for 1 min in an aqueous sodium thiosulphate solution (50 g per liter), rinsed again for 30 s in water, and immersed for 10 s in a solution having the following composition:

potassium hydroxide 10 g
phenylethylpyridinium bromide 30 g
water to make 1 1

After having been dried, the element displayed a negative retained dye image showing 4 visible steps with a maximum density as represented in the accompanying Figure 1 giving the absorption curve, measured in transmission, and with a minimum density of 0.24 measured reflectographically in a MACBETH Densitometer RD 919 in Status A. In Figure 1 the density D is plotted versus the wavelength in nm. The absorption curve clearly has a first absorption peak at 377 nm at density 2.68 and a second peak at 434 nm at density 2.47. These peaks reveal the presence of the two dye units in the redox-activatable compound RA.1. Together these two dye units absorb radiation substantially all over the range between 300 and 450 nm.

It was experienced that a retained image as described above, together with a congruous weak silver image, could constitute a mask that is capable of absorbing substantially all radiation emitted by UV-lamps commonly used for image-wise exposing photopolymer resist materials as used e.g. for lithographic plate making and for printed circuit and integrated circuit production.

**Claims**

1. Dye diffusion transfer imaging process for the production of retained images, characterized in that said process comprises the steps of:

-applying an alkaline aqueous processing composition to an image-wise exposed photographic element that contains in operative association with at least one alkali-permeable silver halide hydrophilic colloid emulsion layer a redox-activatable compound that initially is immobile in an aqueous alkali-permeable colloid medium and is capable of releasing under alkaline conditions in reduced state a diffusible dye moiety,

-providing a silver halide developing agent in said photographic element for being present therein during application of said alkaline aqueous processing composition to cause as a function of development of said silver halide emulsion layer the release of said diffusible dye moiety from said redox-active compound upon reduction thereof at the non-silver compound of releasing said diffusible dye moiety upon oxidation of said redox-activatable compound at the silver image areas and

-allowing diffusion of said diffusible dye moiety into an extracting liquid or disposable receptor medium and leaving in said photographic element a silver image as well as an UV-absorbing dye

image retained congruously with said silver image,
said redox-activatable compound comprising at least two dye units or dye precursor units, which together absorb radiation substantially all over the range between 300 and 450 nm.

2. A process according to claim 1, characterized in that said redox-activatable compound is represented by the following general formula:

CAR - L - D

wherein :

CAR represents a carrier moiety,

L represents a chemical group cleavable or releasable from the carrier moiety by a redox reaction in alkaline aqueous medium, and

D represents a dye moiety or dye precursor moiety containing several dye units or dye precursor units, each of which has an absorption maximum between 300 and 450 nm and together absorbing radiation substantially all over the range between 300 and 450 nm, said dye units or dye precursor units being linked chemically to each other by:

-a non-metal atom bearing only single bonds, or

-a polyvalent atom group wherein one atom links the dye units together by single bonds only, or

-a polyvalent atom group forming between the dye units a chain of atoms wherein at least one atom of the interlinking atoms of the backbone part of said chain has two consecutive single bonds in said backbone part.

3. Photographic silver halide element comprising on a transparent support at least one alkali-permeable silver halide hydrophilic colloid emulsion layer and operatively associated with said emulsion layer a redox-activatable compound that initially is immobile in an aqueous alkali-permeable colloid medium and is capable of releasing under alkaline conditions in reduced state a diffusible dye moiety, characterized in that said redox-activatable compound comprises at least two dye units or dye precursor units, which together absorb radiation substantially all over the range between 300 and 450 nm.

4. A photographic silver halide element according to claim 3, characterized in that said redox-activatable compound is represented by the general formula given in claim 2.

5. A photographic silver halide element according to claim 4, characterized in that said moiety D corresponds to the following general formula:

$-(A)_x[-B(-C)_y]_z$

wherein :

A is $L^1$, $L^1D^1$ or $D^1$,

B is $L^2$, $L^2D^2$ or $D^2$,

C is $L^3$, $L^3D^3$ or $D^3$,

x is 0 or 1,

y is 0, 1, 2 or 3, and

z is 1, 2 or 3,

so that the above formula comprises at least 2 members selected from $D^1$, $D^2$ and $D^3$ and that when y and/or z are 2 or 3, both the several B-groups and the several C-groups have same or different meanings, and wherein :

each of $L^1$, $L^2$ and $L^3$ (same or different) represents a non-conjugating linking member being a collective expression for:

-a non-metal atom bearing only single bonds, or

-a polyvalent atom group wherein one atom links the dye units together by single bonds only, or

-a polyvalent atom group forming between the dye units a chain of atoms wherein at least one atom of the interlinking atoms of the backbone part of said chain has two consecutive single bonds in said backbone part, and

each of $D^1$, $D^2$, and $D^3$ (same or different) represents a dye unit or dye precursor unit having an absorption maximum between 300 and 450 nm, the members present of $D^1$, $D^2$, and $D^3$ together absorbing radiation substantially all over the range between 300 and 450 nm.

6. A photographic silver halide element according to claim 5, characterized in that said general formula comprises from 2 to 5 members selected from $D^1$, $D^2$, and $D^3$.

7. A photographic silver halide element according to any of claims 3 to 6, characterized in that said redox-activatable compound corresponds to the following structural formula:

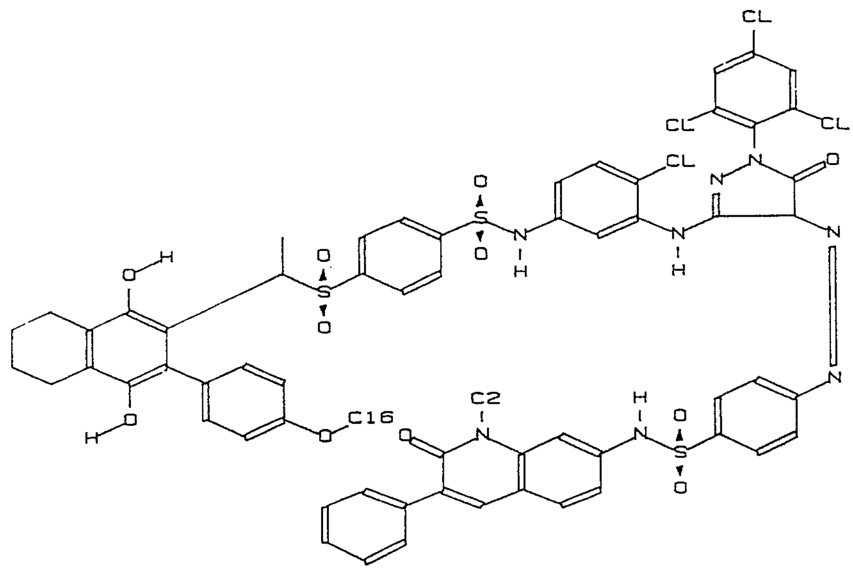

8. A photographic silver halide element according to any of claims 3 to 7, characterized in that said silver halide emulsion layer is a pure silver chloride emulsion layer.

9. A photographic silver halide element according to claim 8, characterized in that the silver chloride of said silver chloride emulsion layer has been sensitized chemically with rhodium.

10. A photographic silver halide element according to any of claims 3 to 9, characterized in that said silver halide emulsion layer has a silver content equivalent to 0.3 - 1.5 g of silver nitrate per m2.

11. A photographic silver halide element according to any of claims 3 to 10, characterized in that the amount of redox-activatable compound varies between 0.1 and 1.5 g per m2 of photographic element.

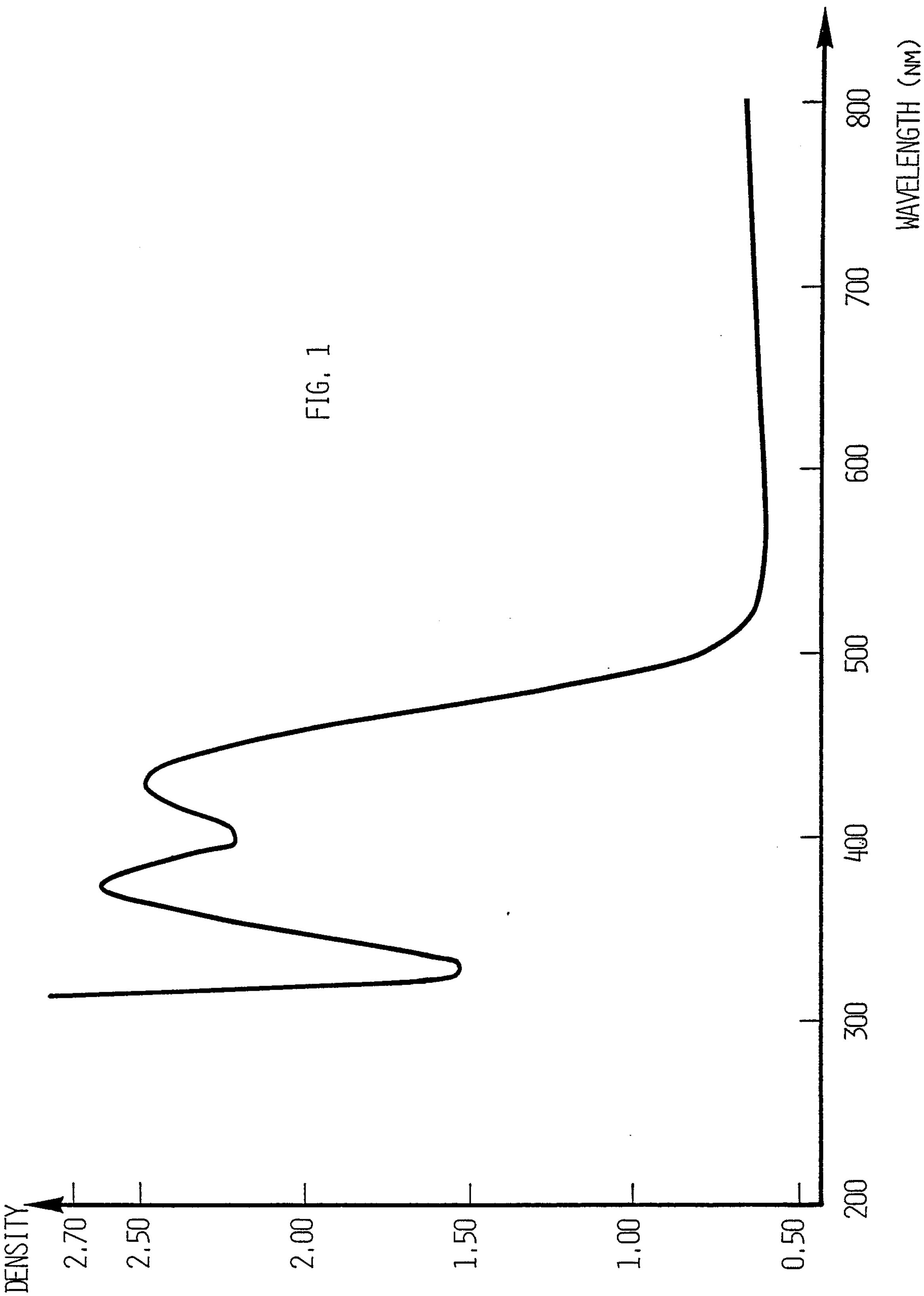
DENSITY
2.70
2.50
2.00
1.50
1.00
0.50
200
300
400
500
600
700
800
WAVELENGTH (NM)

FIG. 1

European Patent Office

# EUROPEAN SEARCH REPORT

Application number

EP 86 20 1619

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,Y | RESEARCH DISCLOSURE, no. 227, March 1983, pages 118-120, no. 22711, Industrial Opportunities, Havant, Hampshire, GB; R.LEMAHIEU et al.: "Process for the production of colour images by image-wise retaining dye providing compounds in a photographic silver halide emulsion material" * Page 120, left-hand column, last bottom paragraph * | 1-11 | G 03 C 5/54 //<br>G 03 F 1/00<br>C 09 B 29/48<br>C 09 B 41/00 |
| D,Y | EP-A-0 149 260 (AGFA-GEVAERT) * Page 40, lines 6-13; claims * | 1-7,11 | |
| Y | EP-A-0 128 663 (KONISHIROKU PHOTO INDUSTRY) | 8,9 | **TECHNICAL FIELDS SEARCHED (Int. Cl.4)** |
| | | | G 03 C 5<br>G 03 F 1<br>C 09 B 29 |

The present search report has been drawn up for all claims

| Place of search | Date of completion of the search | Examiner |
|---|---|---|
| THE HAGUE | 08-05-1987 | PHILOSOPH L.P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82